# EUROPÄISCHE PATENTSCHRIFT

(11) **EP 0 589 935 B1**
(45) Veröffentlichungstag und Bekanntmachung des Hinweises auf die Patenterteilung: **02.11.1994**
(21) Anmeldenummer: 92911629.1
(22) Anmeldetag: 11.06.1992
(51) Int. Cl.: G01R 31/34, G01B 5/00

(54) **INSPEKTION EINER DYNAMOELEKTRISCHEN MASCHINE IN EINEM SPALT ZWISCHEN STATOR UND ROTOR**
INSPECTION OF A DYNAMO-ELECTRIC MACHINE IN A GAP BETWEEN STATOR AND ROTOR
INSPECTION DE MACHINES DYNAMOELECTRIQUES EFFECTUEE DANS UN ESPACE SEPARANT LE STATOR DU ROTOR

(30) Priorität: 21.06.1991 EP 91110269; 04.07.1991 EP 91111160; 03.09.1991 DE 9110922 U
(43) Veröffentlichungstag der Anmeldung: 06.04.1994
(73) Patentinhaber: SIEMENS AKTIENGESELLSCHAFT, 80333 München (DE)
(72) Erfinder: KOHLERT, Erich, D-8520 Erlangen (DE); WIRXEL, Otto, D-4300 Essen (DE)
(86) Internationale Anmeldenummer: EP9201315
(87) Internationale Veröffentlichungsnummer: WO9300592

(56) Entgegenhaltungen:
- US-A- 2 596 322

## Beschreibung

### Inspektion einer dynamoelektrischen Maschine in einem Spalt zwischen Stator und Rotor

Die Erfindung betrifft Instrumententräger und Verfahren zur Inspektion einer dynamoelektrischen Maschine, die einen Stator mit einem ferromagnetischen Joch und einen Rotor aufweist, der in einer Innenausnehmung des Joches angeordnet ist unter Belassung eines Spaltes zwischen dem Stator und dem Rotor, wobei zur Durchführung der Inspektion Instrumente in den Spalt zwischen dem Stator und dem Rotor eingeführt werden.

Die Gewährleistung des störungsfreien Betriebes einer dynamoelektrischen Großmaschine, insbesondere eines Turbogenerators, sowie die rechtzeitige Feststellung einer sich anbahnenden Fehlfunktion einer solchen Maschine erfordert die regelmäßige, in Intervallen von mehreren Monaten bis zu einigen Jahren wiederholte Inspektion der Bestandteile der Maschine, wobei stets vielfältige Untersuchungen und Prüfungen vorzunehmen sind. Eine mögliche Prüfung ist dabei die optische Inspektion der entsprechend zugänglichen Oberflächen der Komponenten der Maschine, insbesondere der Oberflächen des Stators und des Rotors. Weitere mögliche Prüfungen umfassen die Inspektion der Komponenten mittels Ultraschall nach verschiedenen Verfahren, sowie Überprüfungen der Magnetisierbarkeit des in jeder dynamoelektrischen Maschine vorhandenen Joches (das in einem Stator aus aufeinandergeschichteten Blechen besteht). Für eine solche Prüfung kann beispielsweise die Einwirkung schwacher und lokal begrenzter Magnetfelder auf das Joch bestimmt und ausgewertet werden. Schließlich sind auch mechanische Prüfungen, insbesondere Festigkeitsprüfungen und Prüfungen auf eventuell vorhandene Risse, durchzuführen. Nicht zuletzt sind Möglichkeiten erwünscht, kleinere Teile, wie z. B. gelöste Schrauben oder dgl., aus der Maschine bergen zu können.

Die üblichen Methoden zur Inspektion einer dynamoelektrischen Maschine erfordern die Entfernung des drehbaren Teils, des Rotors, was insbesondere im Fall dynamoelektrischer Großmaschinen mit elektrischen Leistungsabgaben von mehreren 100 MVA höchst zeitraubend und kostenaufwendig ist.

Um solche aufwendigen Demontagearbeiten nach Möglichkeit entbehrlich zu machen ist eine Einrichtung bekannt, die es gestattet, in einer dynamoelektrischen Großmaschine durch den Spalt zwischen Stator und Rotor (der üblicherweise ungeachtet des in der Maschine installierten Kühlsystems als "Luftspalt" bezeichnet wird) eine Instrumentenplattform zu ziehen, die an Führungsschienen, die von einem Ende der Großmaschine zum anderen durch den Spalt hindurchgeführt sind, entlang läuft.

Aus der US-PS 4 255 762 ist eine Einrichtung zur Inspektion von Rohren bekannt, bei der eine Sonde mit einem optischen Inspektionssystem an einem Tragarm in das zu inspizierende Rohr eingeführt wird. Eine solche Einrichtung ist in dynamoelektrischen Maschinen nur mit Einschränkungen verwendbar, da die zu inspizierenden Spalte in diesen Maschinen oftmals mehrere Meter lang sind bei Spalthöhen von nur wenigen Zentimetern. Tragarme solcher Länge sind vibrationsfrei und unter Vermeidung von Berührungen des Stators oder Rotors kaum einsetzbar, so daß eine Übertragung dieser bekannten Anwendung auf die Inspektion dynamoelektrischer Maschinen nicht praktikabel ist.

Das US-Patent 2 596 322 betrifft einen selbstfahrenden Träger für Schweiß- oder Schneidwerkzeuge zur Bearbeitung von Rohren. Der Träger weist Räder auf, in die Magnete eingebaut sind, um den Träger auf einem zu bearbeitenden Rohr festzuhalten. Bestimmungsgemäß soll der Träger das Rohr in Umfangsrichtung umfahren und dabei einen geraden oder schrägen Schnitt machen oder einen Schweißvorgang durchführen.

Die US-Patente 4 889 000, 4 970 890 und 5 105 658 betreffen ein System zur Inspektion eines Generators, welches eine selbstfahrende Einrichtung umfaßt, die einen Spalt zwischen einem Stator und einem Rotor des Generators befahren kann. Die Einrichtung trägt verschiedene Mittel zur Inspektion des Generators und ist verbunden mit einer Steuer- und Auswerteinrichtung zur Durchführung der Inspektion.

Aufgabe der Erfindung ist es, einen Instrumententräger sowie ein Verfahren zur Inspektion einer dynamoelektrischen Maschine in einem Spalt zwischen Stator und Rotor anzugeben, wobei Instrumente sicher und vibrationsfrei, auch und insbesondere über Distanzen der Größenordnung mehrerer Meter, in den Spalt einführbar und dort bewegbar sind sowie keine komplizierten Führungseinrichtungen benötigt werden.

Zur Lösung dieser Aufgabe weist erfindungsgemäß ein Instrumententräger zur Inspektion einer dynamoelektrischen Maschine, die einen Stator mit einem ferromagnetischen Joch und einen Rotor aufweist, der in einer Innenausnehmung des Joches angeordnet ist unter Belassung eines Spaltes zwischen dem Stator und dem Rotor, welcher Instrumententräger in den Spalt einführbar ist, weist folgende Bestandteile auf:
a) ein Rahmenteil, an dem Mittel zur Inspektion der dynamoelektrischen Maschine befestigt sind;
b) zumindest einen ersten Radsatz mit zumindest drei ersten Rädern, mit denen der Instrumententräger in dem Spalt bewegbar ist, wobei jedes erste Rad um eine erste Achse drehbar ist und alle ersten Achsen parallel zueinander sind;
c) eine Anschlußvorrichtung von Leitungen zur Verbindung des Instrumententrägers mit einer Steuer- und Auswerteeinrichtung;
   gekennzeichnet durch
d) zumindest einen Magneten, mit dem der Instrumententräger auf den ersten Rädern in dem Spalt an das Joch anpreßbar ist.

Die Mittel zur Inspektion der dynamoelektrischen Maschine sind auswählbar aus einer großen Vielfalt von optischen, akustischen und mechanischen Instrumenten sowie aus einer großen Vielfalt von Hilfseinrichtungen wie z. B. Lampen, Greifern sowie hydraulischen und pneumatischen Einrichtungen.

Der Instrumententräger ist über entsprechende Steuerleitungen mit außerhalb der dynamoelektrischen Maschine angeordneten Steuereinrichtungen verbindbar und wird über magnetische Kräfte an dem Joch festgehalten. Er kann damit in erster Linie parallel zur Drehachse des Rotors durch den Spalt fahren und benötigt keine starren Führungseinrichtungen wie Schienen, o. dgl., die vor dem Einbringen des Instrumententrägers auf irgendeine Weise durch den Generator hindurchgezogen werden müßten und stets die Gefahr der Beeinträchtigung der Instrumente durch Vibrationen, neben anderen Problemen, mit sich bringen.

Der Instrumententräger stützt sich unmittelbar an der Stelle, wo er sich gerade befindet, an dem Stator ab, ist somit stets zuverlässig und vibrationsfrei postierbar und gestattet daher an jeder Stelle eine exakte und reproduzierbare Prüfung des Stators und/oder des Rotors. Es versteht sich, daß die Abmessungen des Instrumententrägers an die Abmessungen des zu befahrenden Spaltes angepaßt werden müssen. Da üblicherweise Luftspalte in dynamoelektrischen Großmaschinen um etwa 5 Zentimeter hoch sind, stellt dies jedoch kein wesentliches Problem dar. Auch sind für Inspektionen Instrumente jedweder benötigten Art in hinreichender Miniaturisierung verfügbar, so daß auch von dieser Seite die Erfindung keinerlei Beschränkung der gewünschten Inspektionsmethoden erfordert.

Der Instrumententräger ist mit einer großen Vielfalt von Instrumenten ausrüstbar: Es sind optische Inspektionseinrichtungen, z. B. Videokameras, gegebenenfalls ergänzt mit entsprechenden Beleuchtungseinrichtungen, denkbar; auch kommen Ultraschallprüfeinrichtungen vielerlei Art, Einrichtungen zur Untersuchung der dynamoelektrischen Maschine mittels Magnetfeldern sowie mechanische Prüfeinrichtungen zur Durchführung von Festigkeitsprüfungen und dergleichen in Frage. Weiterhin ist es denkbar, den Instrumententräger mit mechanischen Manipulatoren, beispielsweise Greifern, zur Bergung loser Teile oder zur Durchführung kleinerer Reparaturen und Wartungsarbeiten auszurüsten.

Im Rahmen einer besonders bevorzugten Weiterbildung hat der Instrumententräger zumindest einen ersten Motor, insbesondere einen Elektromotor, mit dem der erste Radsatz antreibbar ist. Damit stellt er eine selbstfahrende, über entsprechende Steuerleitungen fernbedienbare Einrichtung dar, die keinerlei kraftübertragender Mittel, insbesondere keiner Seile oder dergleichen mehr bedarf, um durch den Spalt zu fahren. Somit ist der Instrumententräger praktisch vollständig frei von externen mechanischen Einwirkungen in dem Spalt einsetzbar.

In dem Instrumententräger sind, neben den selbstverständlich ebenfalls einsetzbaren Elektromagneten, insbesondere Permanentmagnete zum Anpressen des Instrumententrägers an das Joch der zu inspizierenden dynamoelektrischen Maschine verwendbar; es kommen sowohl metallische Permanentmagnete auf Eisen-, Kobalt- oder Nickelbasis, ggf. aus Legierungen und/oder intermetallischen Verbindungen mit Metallen aus der Gruppe der Seltenen Erden (beispielsweise Samarium) in Frage, da insbesondere Samarium-Kobalt-Permanentmagnete bei begrenzter Bau-Baugröße besonders hohe Magnetfelder erzeugen. Auch kommen Magnete aus Verbundwerkstoffen aus permanentmagnetischen Pulvern in Kunststoffmatrizen in Frage. Ein geeignetes permanentmagnetisches Pulver ist ein Pulver aus einem im wesentlichen aus Neodym, Eisen und Bor bestehenden Werkstoff. Schließlich sind auch Permanentmagnete aus gesinterten Hartferriten anwendbar.

Für die Anbringung des Magneten oder einer Mehrzahl von Magneten gibt es an dem Instrumententräger vielerlei Möglichkeiten; im Prinzip kann ein solcher Magnet an beliebiger Stelle des Instrumententrägers angeordnet werden, wobei er allerdings dem zu befahrenden Joch einer dynamoelektrischen Maschine möglichst nahekommen sollte zur Erzielung einer möglichst hohen Haltekraft. Das Feld des Magneten sollte jedoch die zur eigentlichen Inspektion der dynamoelektrischen Maschine verwendeten Instrumente nicht beeinträchtigen. Um letzteres zu verhindern ist es u. U. vorteilhaft, eine Vielzahl von Magneten in der Weise vorzusehen, daß jeweils ein Magnet in der Nähe eines ersten Rades angeordnet, beispielsweise auf dem Rahmenteil befestigt, wird.

Der Instrumententräger erfordert zur Steuerung und zum Betrieb der der Inspektion dienenden Mittel lediglich den Anschluß von Leitungen, wie z. B. elektrischen Leitungen, zur Verbindung des evtl. vorhandenen ersten Motors, der Instrumente und evtl. vorhandener zusätzlicher Einrichtungen, wie z.B. Beleuchtungseinrichtungen mit einer außerhalb der dynamoelektrischen Maschine postierbaren Steuer- und Auswerteeinrichtung, die beispielsweise ein Kleincomputer sein kann, der mit entsprechenden Schnittstellen ausgerüstet ist. Auch ist es denkbar, einen Instrumententräger mit pneumatischen oder hydraulischen Mitteln, also einem entsprechenden Motor oder entsprechenden Instrumenten (wie z. B. einem Greifer) zu versehen. Flexible Druckleitungen für Gase und/oder Flüssigkeiten können ebenso wie elektrische Leitungen problemlos im Zusammenhang mit dem Instrumententräger, der dann eine entsprechend ertüchtigte Anschlußvorrichtung aufzuweisen hätte, verwendet werden. In keinem Fall erfordert der Instrumententräger das Vorsehen mechanisch starrer Verbindungselemente wie z. B. Schienen. Dies erleichtert die Anwendung im Vergleich mit den bisher üblichen Inspektionseinrichtungen in erheblichem Maße.

Besonders vorteilhaft ist es, in einem Instrumententräger neben dem ersten Radsatz einen zweiten Radsatz mit zumindest drei zweiten Rädern vorzusehen, der über einen eventuell vorhandenen ersten Motor oder einen evtl. vorzusehenden zweiten Motor anzutreiben und so ausgelegt ist, daß der Instrumententräger auf ihm senkrecht zu der Richtung, in der er auf dem ersten Radsatz bewegbar ist, verfahren werden kann. Ein solcher Instrumententräger ist besonders günstig anwendbar zur Inspektion einer dynamoelektrischen Maschine mit einer etwa zylindrischen Innenausnehmung des Joches: Auf dem ersten Radsatz kann der Instrumententräger parallel, auf dem alternativ zum ersten Radsatz einsetzbaren zweiten Radsatz tangential zur Achse der Innenausnehmung bewegt werden. Auf diese Weise kann er jeden Ort auf der Innenausnehmung erreichen, ohne daß er mit externen Hilfsmitteln oder durch Bedienungspersonal versetzt werden müßte. Der um den zweiten Radsatz ertüchtigte Instrumententräger ermöglicht damit eine weitestgehende Automatisierung der Inspektion, was in Anbetracht der bei einer solchen Inspektion in der Regel anfallenden enormen Kosten besonders vorteilhaft ist.

Das alternative Aufsetzen des ersten Radsatzes und des zweiten Radsatzes auf die Innenausnehmung des Joches erfolgt günstigerweise mit einer Hebeeinrichtung, die z. B. über einen besonderen Motor betrieben werden und in einer Heberichtung senkrecht zu den ersten Achsen und den zweiten Achsen den ersten Radsatz relativ zum zweiten Radsatz verschieben kann. Denkbar ist es, jedes zweite Rad in der Hebeeinrichtung verschiebbar an dem Rahmenteil des Instrumententrägers anzulenken und ggf. alle zweiten Räder im Gleichlauf relativ zu den ersten Rädern zu verschieben; auch oder zusätzlich zu dem Rahmenteil kann ein gegenüber diesem in der Heberichtung verschiebbarer Hilfsrahmen (oder eine Mehrzahl solcher Hilfsrahmen) vorgesehen werden, an dem bzw. an denen die Räder des zweiten Radsatzes zu befestigen sind.

Wie bereits erwähnt, empfiehlt sich insbesondere das Vorsehen einer Vielzahl von Magneten an dem Instrumententräger in der Weise, daß jeder Magnet einem Rad, also einem ersten Rad oder ggf. einem zweiten Rad, zugeordnet ist. Der Magnet kann in der Nähe des entsprechenden Rades an dem Instrumententräger befestigt sein. Besonders günstig ist es, den Magneten mit dem entsprechenden Rad zu vereinigen in der Weise, daß jedes betreffende Rad einen rotationssymmetrischen, insbesondere zylindrischen, und axial zu der Achse des Rades ausgerichteten Magneten mit einer zu der Achse axialen Innenbohrung aufweist, in welche Innenbohrung eine Nabe eingepaßt ist; der Magnet bildet somit einen Bestandteil des Rades. Selbstverständlich kann das Rad zusätzliche Bauteile haben, was insbesondere für Magnete aus spröden Werkstoffen wünschenswert ist. Insbesondere kann an den Magneten in axialer Richtung auf zumindest eine Seite eine nicht-ferromagnetische, runde Scheibe angedrückt sein, die bezüglich der Achse einen geringfügig größeren Durchmesser hat als der Magnet, so daß das Rad nicht oder nicht nur auf dem Magneten, sondern zumindest hauptsächlich auf der Scheibe rollt. Außerdem kann der Magnet mit einer festen, insbesondere metallischen Hülse umgeben werden, auf der das Rad ohne besondere Beanspruchung des Magneten rollen kann. Eine an dem Magneten angebrachte Scheibe kann auch zur Führung des Rades auf einem mit Nuten versehenen Joch, wie es in dynamoelektrischen Maschinen in aller Regel vorkommt, verwendet werden; das Rad kann in der Weise auf dem Joch abrollen, daß die Scheibe unmittelbar an einer Kante der Nut im Bereich ihrer Öffnung ein wenig in die Nut hineinragt. Eine solche Führung ermöglicht eine weiterhin verbesserte Positionssicherung des Instrumententrägers, was der Präzision und Reproduzierbarkeit der zur Inspektion durchzuführenden Messungen weiter entgegenkommt.

Zur Lösung der der Erfindung zugrundeliegenden Aufgabe im Hinblick auf ein Verfahren wird ein Verfahren zur Inspektion einer dynamoelektrischen Maschine, die einen Stator mit einem ferromagnetischen Joch und einen Rotor aufweist, der in einer Innenausnehmung des Joches angeordnet ist unter Belassung eines Spaltes zwischen dem Joch und dem Rotor, angegeben, wobei ein Instrumententräger, der Mittel zur Inspektion der Maschine trägt, in den Spalt eingeführt und dabei durch zumindest einen Magneten an das Joch angepreßt wird. Günstigerweise rollt der Instrumententräger auf ersten Rädern auf dem Joch.

Die Erfindung betrifft auch eine dynamoelektrische Maschine mit einem Stator mit einem ferromagnetischen Joch und einem Rotor, der unter Belassung eines Spaltes in einer Innenausnehmumg des Joches angeordnet ist, wobei ein erfindungsgemäßer Instrumententräger in dem Spalt angeordnet ist.

Die weitere Erläuterung der Erfindung erfolgt anhand der in der Zeichnung schematisiert und, wo zur klaren Darstellung der Erfindung dienlich, leicht verzerrt dargestellten Ausführungsbeispiele. Im einzelnen zeigen:
Fig. 1 einen erfindungsgemäßen Instrumententräger in einer dynamoelektrischen Maschine;
Fig. 2 eine schematisierte Draufsicht auf einen mit Instrumenten ausgerüsteten Instrumententräger;
Fig. 3 einen Querschnitt durch eine spezielle Ausführungsform des erfindungsgemäßen Instrumententrägers;
Fig. 4 eine Draufsicht auf einen Teil eines weitergebildeten Instrumententrägers.

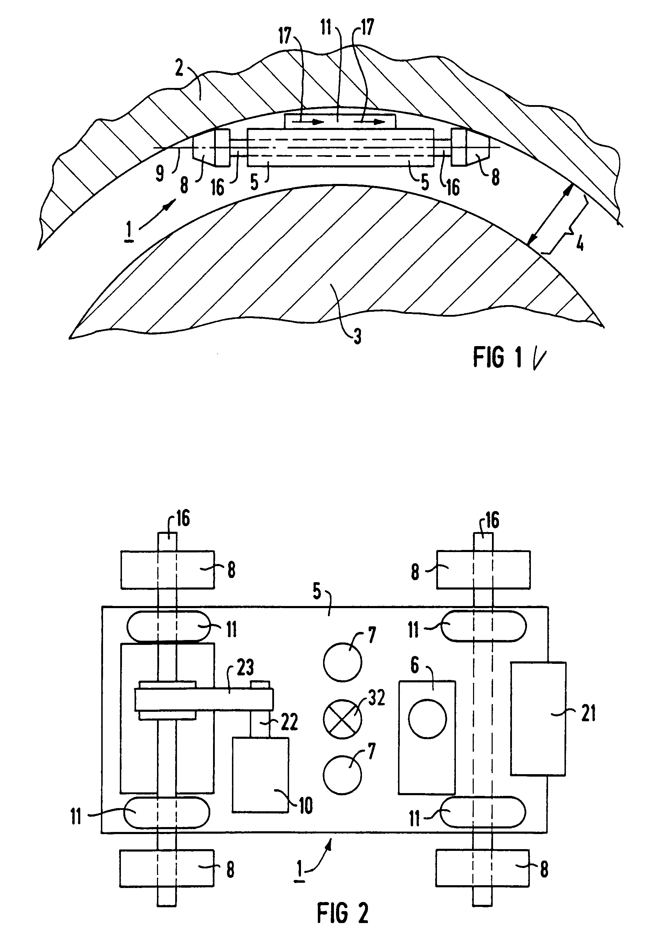

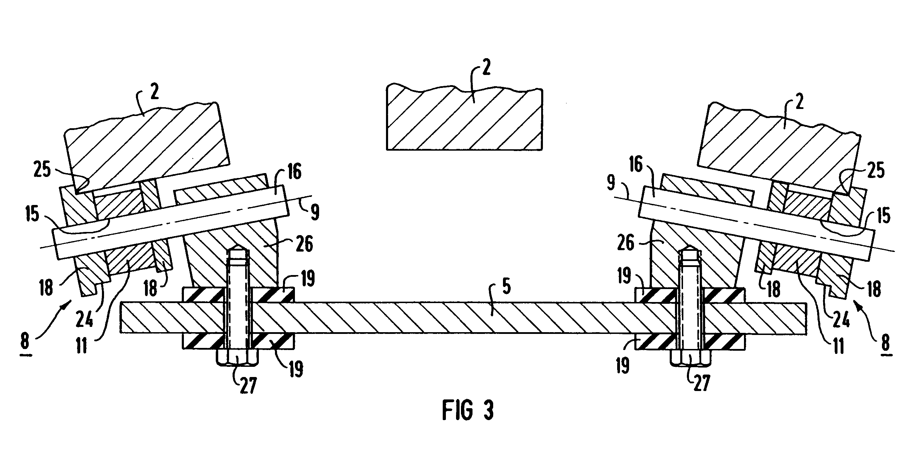

Fig. 1 zeigt wie ein erfindungsgemäßer Instrumententräger 1 in einer dynamoelektrischen Maschine in einem Spalt 4 (dem üblicherweise so bezeichneten "Luftspalt") zwischen einem ferromagnetischen Joch 2 eines Stators der dynamoelektrischen Maschine und einem um eine (nicht dargestellte) Drehachse drehbaren Rotor 3 eingesetzt wird. Der Instrumententräger 1 weist ein Rahmenteil 5 auf und ist mit einem, in diesem Fall am Rahmenteil 5 befestigten, Magneten 11 versehen, der vorzugsweise ein Permanentmagnet mit einer Magnetisierung 17 ist, so daß der Instrumententräger 1 durch magnetische Kräfte zwischen dem Magneten 11 und dem ferromagnetischen Joch 2 an dem Joch 2 festgehalten wird - unabhängig von seiner azimutalen Position. Es versteht sich, daß die Baugrößen des Instrumententrägers 1 den geometrischen Verhältnissen in dem Spalt 4 Rechnung tragen müssen; dies ist jedoch im Rahmen des üblichen fachmännischen konstruktiven Aufwandes erreichbar. Die Fortbewegung des Instrumententrägers 1 an dem Joch 2 erfolgt auf ersten Rädern 8, die jeweils um eine erste Achse 9 drehbar und an dem Rahmenteil 5 angeordnet sind. Im konkreten Fall sind beide ersten Räder 8 verbunden durch eine gleichfalls drehbare Nabe 16, die in dem Rahmenteil 5 in an sich bekannter Weise gelagert ist. Um den Kontakt jedes ersten Rades 8 mit dem Joch 2 zu verbessern, ist im dargestellten Fall jedes erste Rad teilweise kegelig ausgeführt, so daß es nicht nur punktuell an dem Joch 2 anliegt. Dies ist insbesondere zur Vermeidung von Kratzern und Kerben an dem Joch 2 sinnvoll. In Fig. 1 ist das Joch 2 mit einer im wesentlichen kreisförmigen Innenausnehmung dargestellt, da dies zur Erläuterung des der Erfindung zugrunde liegenden Prinzips als günstig anzusehen ist. In der Praxis weist die Innenausnehmung eines Joches 2 in einem Stator eine gewisse und anhand Fig. 3 näher erläuterte Struktur auf, die bei der Auslegung des erfindungsgemäßen Instrumententrägers 1 ggf. zu berücksichtigen ist. Die Auslegung der ersten Räder 8 kann in an sich bekannter Weise den speziellen Anforderungen jedweden Einzelfalles angepaßt werden.

Fig. 2 zeigt eine Draufsicht auf eine Ausführungsform des erfindungsgemäßen Instrumententrägers 1. Der Instrumententräger 1 weist ein Rahmenteil 5 auf, auf dem die Instrumente zur Durchführung einer Inspektion einer dynamoelektrischen Maschine angeordnet sind, und zwar eine Videokamera 6, drei Ultraschall-Prüfköpfe 7 und eine Lampe 32. Diese Instrumente werden stellvertretend für vielfältige andere aufgeführt; der Instrumententräger 1 kann insbesondere auch ausgestattet werden mit Prüfeinrichtungen für die magnetischen Eigenschaften der Komponenten dynamoelektrischer Maschinen sowie mit mechanischen Manipulatoren, wie z. B. Greifern. Insbesondere ist die Instrumentierung nicht auf elektrisch steuerbare Instrumente beschränkt.

Pneumatisch und/oder hydraulisch manipulierbare Einrichtungen können selbstverständlich einbezogen werden. Der Instrumententräger 1 weist vier erste Räder 8 und vier Magneten 11 auf, wobei jedem ersten Rad 8 ein Magnet 11 zugeordnet ist. Jedes erste Rad 8 steckt auf einer in dem Rahmenteil 5 gelagerten Nabe 16. Zum Antrieb des Instrumententrägers 1 dient ein erster Motor 10, insbesondere ein Elektromotor, aus dem eine Antriebswelle 22 herausführt, die über einen Treibriemen 23 mit einer Nabe 16 verbunden ist. Es versteht sich, daß anstelle der Kraftübertragung mittels Treibriemen 23 auch eine Kraftübertragung mittels Gelenkwellen u. dgl. treten kann. Zu bemerken ist auch, daß die Naben 16 nicht notwendigerweise starr sein müssen. Je nach Anforderung können sie auch zumindest abschnittsweise biegbar sein oder Kardangelenke enthalten. Dies insbesondere dann, wenn die Achsen der auf verschiedenen Seiten des Rahmenteiles 5 befindlichen ersten Räder 8 zur Erzielung eines besseren Kontaktes mit dem Joch leicht geneigt zueinander sein müssen. Schließlich ist der erfindungsgemäße Instrumententräger 1 mit einer Anschlußvorrichtung 21, insb. einem an sich bekannten Stecker und/oder einem an sich bekannten Sockel für einen solchen Stecker, oder einem anderen elektrischen, hydraulischen oder pneumatischen Verbindungselement versehen zum Anschluß der verschiedenen Einrichtungen, insb. der Instrumente 6, 7 und des ersten Motors 10, an außerhalb der dynamoelektrischen Maschine zu postierende Steuer- und Auswerteeinrichtungen versehen. Von der Anschlußvorrichtung 21 führen Leitungen zu den Instrumenten 6, 7 bzw. zu dem ersten Motor 10. Der Ubersicht halber sind diese Leitungen nicht dargestellt.

Fig. 3 zeigt einen Querschnitt durch eine besondere Ausführungsform eines auf einem Joch 2 aufsitzenden Instrumententrägers 1 gemäß der Erfindung. Das Joch 2 ist dargestellt in Form dreier "Zähne", zwischen denen Freiräume in Form von Nuten bestehen, in die gemäß üblicher Praxis die elektrischen Wicklungen des Stators einzulegen sind. Die durch das Vorsehen dieser Nuten bedingten Kanten 25 an dem Joch 2 können vorteilhafterweise zur Führung der ersten Räder 8 verwendet werden, indem diese ersten Räder 8 Stufen 24 aufweisen, die zu den Kanten 25 korrespondieren. Im dargestellten Ausführungsbeispiel ist in jedes erste Rad 8 ein Magnet 11, und zwar ein zylindersymmetrischer Magnet 11 mit einer Innenausnehmung 15, integriert. Durch die Innenausnehmung 15 des Magneten 11 ist eine Nabe 16, an der das erste Rad 8 gelagert ist, hindurchgesteckt. Da viele permanentmagnetische Materialien, die für den Magneten 11 in Frage kommen, relativ spröde sind, weist jedes erste Rad 8 auf beiden bezüglich der ersten Achse 9 axialen Endflächen des Magneten 11 aufliegende Scheiben 18 auf, die bezüglich der Achse 9 jeweils einen geringfügig größeren Durchmesser als der Magnet 11 haben, so daß jedes erste Rad 8 auf diesen Scheiben 18 statt auf dem Magneten 11 auf dem Joch 2 aufliegt. Der Schutz des Magneten 11 vor mechanischer Beanspruchung kann ggf. weiter verbessert werden, indem er mit einer (nicht dargestellten) Hülse aus nichtmagnetischem Metall oder Kunststoff umgeben wird. Jeweils eine Scheibe 18 an jedem ersten Rad 8 weist die zur Führung an dem Joch 2 dienende Stufe 24 auf. Die Lagerung jedes ersten Rades 8 erfolgt in einem Lagerblock 26 in an sich bekannter Weise. Jeder Lagerblock 26 ist mittels einer Schraube 27 an dem Rahmenteil befestigt, wobei zur Federung jedes ersten Rades 8 jeweils eine Gummiplatte oder ähnliches zwischen Rahmenteil 5 und Lagerblock 26 bzw. Rahmenteil 5 und Schraube 27 vorgesehen ist.

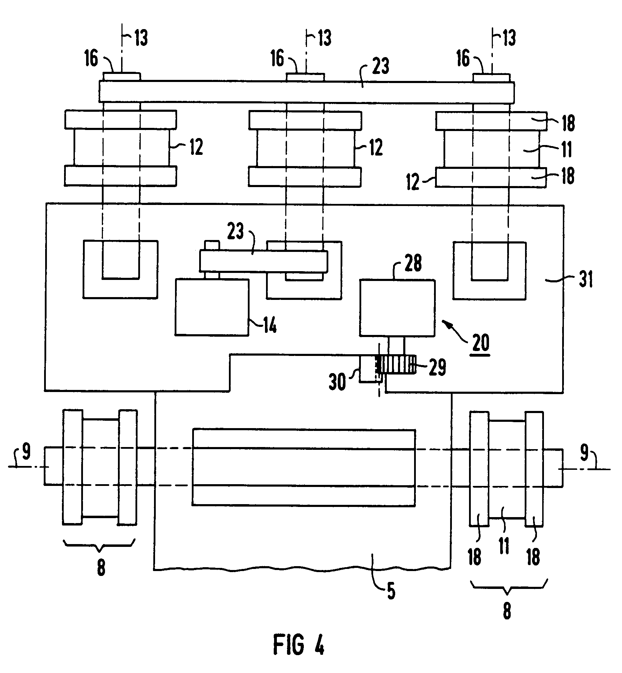

Fig. 4 zeigt einen Ausschnitt aus einer Draufsicht auf einen erfindungsgemäßen Instrumententräger, welcher Instrumententräger außer den erwähnten ersten Rädern 8 mit zweiten Rädern 12 versehen ist und dadurch in zwei senkrecht aufeinanderstehenden Richtungen bewegbar ist, ohne daß Lenkeinrichtungen, die im Rahmen der Erfindung selbstverständlich auch verwendbar sind, erforderlich wären. Erste Räder 8 und zweite Räder 12 sind, wie anhand von Fig. 3 bereits näher ausgeführt, aufgebaut aus rotationssymmetrischen Magneten 11, darauf angebrachten Scheiben 18 sowie Naben 16. Jedes zweite Rad 12 ist drehbar um eine zweite Achse 13, die im wesentlichen senkrecht zu jeder ersten Achse 9 liegt. Der Antrieb der zweiten Räder 12 erfolgt durch einen zweiten Motor 14, der über Treibriemen 23 mit allen zweiten Rädern 12 verbunden ist. Dies ist insbesondere sinnvoll, wenn der Instrumententräger in einem gezahnten Joch ähnlich der Art nach Fig. 3 in azimutaler Richtung über das Joch hinwegbewegt werden soll. In einem solchen Fall kann es vorkommen, daß nicht alle zweiten Räder 12 mit dem Joch 2 in Kontakt sind, was zu Problemen führen könnte, wenn nicht alle zweiten Räder 12 gleichermaßen angetrieben sind. Die zweiten Räder 12 befinden sich nicht unmittelbar an dem Rahmenteil 5, sondern an einem Hilfsrahmen 31, der mittels einer Hebeeinrichtung 20 in einer Heberichtung senkrecht zu den zweiten Achsen 13 und den ersten Achsen 9 verschiebbar ist. Die Hebeeinrichtung 20 ermöglicht einen Betrieb des zweiten Radsatzes mit den zweiten Rädern 12 alternativ zum Betrieb des ersten Radsatzes mit den ersten Rädern 8. Beispielhaft ist die Hebeeinrichtung 20 dargestellt mit einem Hebemotor 28 auf dem Hilfsrahmen 31, der über ein Ritzel 29 mit einer Zahnstange 30 auf dem Rahmenteil 5 in Eingriff ist. Diese Darstellung soll lediglich als Beispiel dienen für die gesamte Fülle der an sich bekannten und hier verwendbaren elektrischen, pneumatischen und hydraulischen Hebeeinrichtungen. Der Instrumententräger gemäß Fig. 4 weist insgesamt zwei Hilfsrahmen 31 auf, jeweils einen an jedem Ende.

Die Erfindung gestattet eine besonders einfache und zuverlässige Inspektion des Stators und/oder des Rotors einer dynamoelektrischen Maschine aus dem Spalt zwischen Stator und Rotor, ohne daß zur Inspektion eine Entfernung des Rotors erforderlich ist. Der Instrumententräger nach der Erfindung erfordert keine mechanisch starren Verbindungs- und Führungselemente wie z. B. Schienen und ist daher in der Anwendung im Vergleich mit den bisher üblichen Inspektionseinrichtungen unproblematisch und kostengünstig.

## Patentansprüche

1. Instrumententräger (1) zur Inspektion einer dynamoelektrischen Maschine, die einen Stator mit einem ferromagnetischen Joch (2) und einen Rotor (3) aufweist, der in einer Innenausnehmung des Joches (2) angeordnet ist unter Belassung eines Spaltes (4) zwischen dem Joch (2) und dem Rotor (3), welcher Instrumententräger (1) in den Spalt (4) einführbar ist und folgende Bestandteile aufweist:
a) ein Rahmenteil (5), an dem Instrumente (6, 7) zur Inspektion der dynamoelektrischen Maschine befestigt sind;
b) zumindest einen ersten Radsatz mit zumindest drei ersten Rädern (8), mit denen der Instrumententräger (1) in dem Spalt (4) bewegbar ist, wobei jedes erste Rad (8) um eine erste Achse (9) drehbar ist und alle ersten Achsen (9) etwa parallel zueinander sind;
c) eine Anschlußvorrichtung (21) zum Anschluß von Leitungen zur Verbindung des Instrumententrägers (1) mit einer Steuer- und Auswerteeinrichtung;
gekennzeichnet durch
d) zumindest einen Magneten (11), darch den der Instrumententräger (1) mit den ersten Rädern (8) in dem Spalt (4) an das Joch (2) anpreßbar ist.

2. Instrumententräger (1) nach Anspruch 1, der zumindest einen ersten Motor (10) aufweist, mit dem der erste Radsatz antreibbar ist.

3. Instrumententräger (1) nach Anspruch 1 oder 2, bei dem der Magnet (11) ein Permanentmagnet ist.

4. Instrumententräger (1) nach einem der vorhergehenden Ansprüche, der einen zweiten Radsatz aufweist mit zumindest drei zweiten Rädern (12), deren Jedes um eine zweite Achse (13) drehbar ist, wobei alle zweiten Achsen (13) parallel zueinander sind, wobei jede erste Achse (9) senkrecht zu Jeder zweiten Achse (13) ist und der Instrumententräger (1) alternativ auf dem ersten oder dem zweiten Radsatz in dem Spalt (4) bewegbar ist.

5. Instrumententräger (1) nach Anspruch 4, mit zumindest einem Hilfsrahmen (31), an dem die zweiten Räder (12) drehbar befestigt sind.

6. Instrumententräger (1) nach Anspruch 4 oder 5, der eine Hebeeinrichtung (20) aufweist, mit der in einer Heberichtung senkrecht zu den ersten Achsen (9) und den zweiten Achsen (13) der erste Radsatz relativ zum zweiten Radsatz verschiebbar ist.

7. Instrumententräger (1) nach einem der Ansprüche 4-6, bei dem jedem ersten Rad (8) bzw. jedem ersten (8) und/oder jedem zweiten Rad (12) ein Magnet (11) zugeordnet ist.

8. Instrumententräger (1) nach Anspruch 7, bei dem jedes erste Rad (8) bzw. jedes erste (8) und/oder jedes zweite Rad (12) einen rotationssymmetrischen, insbesondere zylindrischen, und axial zu der Achse (9; 13) ausgerichteten Magneten (11) mit einer zu der Achse (9; 13) axialen Innenbohrung (15) aufweist, wobei
a) in die Innenbohrung (15) eine Nabe (16) eingepaßt ist;
b) der Magnet (11) eine Magnetisierung (17) aufweist, die etwa parallel zu der Achse (9; 13) ausgerichtet ist.

9. Instrumententräger (1) nach Anspruch 8, bei dem
a) an den Magneten (11) in axialer Richtung auf zumindest einer Seite eine nicht-ferromagnetische, runde Scheibe (18) angedrückt ist;
b) der Magnet (11) und die Scheibe (18) senkrecht zur Achse (9; 13) jeweils einen Durchmesser haben und der Durchmesser der Scheibe (18) geringfügig größer als der Durchmesser des Magneten (11) ist.

10. Instrumententräger (1) nach einem der Ansprüche 4-9, bei dem jedes erste Rad (8) bzw. zweite Rad (12) eine Federung (19), insb. eine Federung (19) mit zumindest einer gummielastischen Platte, aufweist.

11. Instrumententräger (1) nach einem der vorhergehenden Ansprüche, der zumindest vier erste Räder (8) und zumindest vier zweite Räder (12) aufweist.

12. Instrumententräger (1) nach einem der vorhergehenden Ansprüche, bei dem die Instrumente (6, 7, 23) zur Inspektion eine Videokamera (6) und/oder einen Ultraschallprüfkopf (7), sowie Hilfseinrichtungen, insbesondere eine Lampe (23), umfassen.

13. Verfahren zur Inspektion einer dynamoelektrischen Maschine, die einen Stator mit einem ferromagnetischen Joch (2) und einen Rotor (3) aufweist, der in einer Innenausnehmung des Joches (2) angeordnet ist unter Belassung einen Spaltes (4) zwischen dem Joch (2) und dem Rotor (3), wobei ein Instrumententräger (1), der Mittel (6, 7, 32) zur Inspektion der Maschine trägt, in den Spalt (4) eingeführt wird, dadurch gekennzeichnet, daß der Instrumententräger (1) durch zumindest einen Magneten (11) an das Joch (2) angepreßt wird.

14. Verfahren nach Anspruch 13,bei dem der Instrumententräger (1) auf ersten Rädern (8) auf dem Joch (2) rollt.

15. Dynamoelektrische Maschine mit einem Stator mit einem ferromagnetischen Joch (2) und einem Rotor (3), der unter Belassung eines Spaltes (4) in einer Innenausnehmung des Joches (2) angeordnet ist, wobei ein Instrumententräger (1) nach einem der Ansprüche 1 bis 12 in dem Spalt (4) angeordnet ist.

## Claims

1. Instrument carrier (1) for the inspection of a dynamoelectric machine which has a stator with a ferromagnetic yoke (2) and a rotor (3) which is arranged in an internal recess of the yoke (2) to leave a gap (4) between the yoke (2) and the rotor (3), which instrument carrier (1) can be inserted into the gap (4) and has the following components:
a) a frame part (5) to which instruments (6, 7) for the inspection of the dynamoelectric machine are attached;
b) at least a first wheel set having at least three first wheels (8) with which the instrument carrier (1) can be moved in the gap (4), each first wheel (8) being rotatable about a first axis (9) and all the first axes (9) being approximately parallel to one another;
c) a connection device (21) to connect lines for connecting the instrument carrier (1) to a control and evaluation device;
characterized by
d) at least one magnet (11) by means of which the instrument carrier (1) with the first wheels (8) in the gap (4) can be pressed against the yoke (2).

2. Instrument carrier (1) according to Claim 1, which has at least a first motor (10) with which the first wheel set can be driven.

3. Instrument carrier (1) according to Claim 1 or 2, in which the magnet (11) is a permanent magnet.

4. Instrument carrier (1) according to one of the preceding claims, which has a second wheel set with at least three second wheels (12), of which each is rotatable about a second axis (13), all the second axes (13) being parallel to one another, each first axis (9) being perpendicular to each second axis (13), and the instrument carrier (1) being alternatively movable on the first or the second wheel set in the gap (4).

5. Instrument carrier (1) according to Claim 4, having at least one auxiliary frame (31) to which the second wheels (12) are rotatably attached.

6. Instrument carrier (1) according to Claim 4 or 5, which has a lifting device (20) with which the first wheel set can be displaced relative to the second wheel set in a lifting direction perpendicular to the first axes (9) and the second axes (13).

7. Instrument carrier (1) according to one of Claims 4-6, in which each first wheel (8) or each first (8) and/or each second wheel (12) is assigned a magnet (11).

8. Instrument carrier (1) according to Claim 7, in which each first wheel (8) or each first (8) and/or each second wheel (12) has a rotationally symmetrical, in particular cylindrical, magnet (11), which is aligned axially with respect to the axis (9; 13) and has an internal bore (15) that is axial with respect to the axis (9; 13),
a) a hub (16) being fitted into the internal bore (15); and
b) the magnet (11) having a magnetization (17) which is aligned approximately parallel to the axis (9; 13).

9. Instrument carrier (1) according to Claim 8, in which
a) a non-ferromagnetic, round disc (18) is pressed against the magnet (11) in the axial direction on at least one side; and
b) the magnet (11) and the disc (18) each have a diameter perpendicular to the axis (9; 13) and the diameter of the disc (18) is slightly larger than the diameter of the magnet (11).

10. Instrument carrier (1) according to one of Claims 4-9, in which each first wheel (8) or second wheel (12) has a spring system (19), in particular a spring system (19) with at least one rubbery plate.

11. Instrument carrier (1) according to one of the preceding claims, which has at least four first wheels (8) and at least four second wheels (12).

12. Instrument carrier (1) according to one of the preceding claims, in which the instruments (6, 7, 23) for inspection comprise a video camera (6) and/or an ultrasonic probe (7), and auxiliary devices, in particular a lamp (23).

13. Method for the inspection of a dynamoelectric machine which has a stator with a ferromagnetic yoke (2) and a rotor (3) which is arranged in an internal recess of the yoke (2) to leave a gap (4) between the yoke (2) and the rotor (3), an instrument carrier (1) which carries means (6, 7, 32) for the inspection of the machine being inserted into the gap (4), characterized in that the instrument carrier (1) is pressed by at least one magnet (11) against the yoke (2).

14. Method according to Claim 13, in which the instrument carrier (1) rolls on first wheels (8) on the yoke (2).

15. Dynamoelectric machine having a stator with a ferromagnetic yoke (2) and a rotor (3) which is arranged in an internal recess of the yoke (2) to leave a gap (4), an instrument carrier (1) according to one of Claims 1 to 12 being arranged in the gap (4).

## Revendications

1. Support d'instruments (1) pour l'inspection d'une machine dynamoélectrique qui comporte un stator pourvu d'une culasse ferromagnétique (2) et un rotor (3) qui est disposé dans un évidement à l'intérieur de la culasse (2), tout en laissant subsister une fente (4) entre la culasse (2) et le rotor (3), lequel support d'instruments (1) peut être introduit dans la fente (4) et possède les composants suivants :
a) une partie formant cadre (5), à laquelle sont fixés des instruments (6, 7) servant à inspecter la machine dynamoélectrique;
b) au moins un premier ensemble de roues comportant au moins trois premières roues (8), au moyen desquelles le support d'instruments (1) peut être déplacé dans la fente (4), chaque première roue (8) pouvant tourner autour d'un premier axe (9), et les premiers axes (9) étant tous approximativement parallèles entre eux;
c) un dispositif de raccordement (21) pour raccorder des conducteurs servant à relier le support d'instruments (1) à un dispositif de commande et d'évaluation;
caractérisé par
d) au moins un aimant (11), au moyen duquel le support d'instrument (1) pourvu des premières roues (8) peut être repoussé, dans la fente (4), contre la culasse (2).

2. Support d'instruments (1) suivant la revendication 1, qui comporte au moins un premier moteur (10), au moyen duquel le premier ensemble de roues peut être entraîné.

3. Support d'instruments (1) suivant la revendication 1 ou 2, dans lequel l'aimant (11) est un aimant permanent.

4. Support d'instruments (1) suivant l'une des revendications précédentes, qui comporte un second ensemble de roues possédant au moins trois secondes roues (12), dont chacune peut tourner autour d'un second axe (13), les seconds axes (13) étant tous parallèles entre eux, tandis que chaque premier axe (9) est perpendiculaire à chaque second axe (13) et que le support d'instruments (1) peut être déplacé alternativement sur le premier ensemble de roues ou sur le second ensemble de roues, dans la fente (4).

5. Support d'instruments (1 ) suivant la revendication 4, comportant au moins un cadre auxiliaire (31), sur lequel les secondes roues (12) sont fixées de manière à pouvoir tourner.

6. Support d'instruments (1) suivant la revendication 4 ou 5, qui possède un dispositif de levage (20), au moyen duquel le premier ensemble de roues peut être déplacé par rapport au second ensemble de roues, dans une direction de soulèvement perpendiculaire aux premiers axes (9) et aux seconds axes (13).

7. Support d'instruments (1) suivant l'une des revendications 4-6, dans lequel un aimant (11) est associé à chaque première roue (8) ou à chaque première roue (8) et/ou à chaque seconde roue (12).

8. Support d'instruments (1) suivant la revendication 7, dans lequel chaque première roue (8) et/ou chaque seconde roue (12) possède un aimant à symétrie de révolution, notamment cylindrique (11), orienté dans la même direction que l'axe (9,13) et possède un perçage intérieur (15) qui s'étend dans la direction de l'axe (9;13), et
a) un moyeu (16) monté dans le perçage intérieur (15);
b) l'aimant (11) possède une aimantation (17), qui est dirigée approximativement parallèlement à l'axe (9;13).

9. Support d'instruments (1) suivant la revendication 8, dans lequel
a) un disque circulaire non ferromagnétique (18) est repoussé contre au moins une face de l'aimant (11), dans la direction axiale;
b) l'aimant (11) et le disque (18) possèdent chacun un diamètre perpendiculaire à l'axe (9;13) et le diamètre du disque (18) est légèrement supérieur au diamètre de l'aimant (11).

10. Support d'instruments (1) suivant l'une des revendications 4-9, dans lequel chaque première roue (8) ou seconde roue (12) possède une suspension élastique (19), notamment une suspension élastique (19) comportant au moins une plaque présentant l'élasticité du caoutchouc.

11. Support d'instruments (1) suivant l'une des revendications précédentes, qui comporte au moins quatre premières roues (8) et au moins quatre secondes roues (12).

12. Support d'instruments (1) suivant l'une des revendications précédentes, dans lequel les instruments (6,7,23) utilisés pour l'inspection comprennent une caméra vidéo (6) et/ou une tête de contrôle à ultrasons (7), ainsi que des dispositifs auxiliaires, notamment une lampe (23).

13. Procédé pour l'inspection d'une machine dynamoélectrique, qui comporte un stator pourvu d'une culasse ferromagnétique (2), et un rotor (3) qui est disposé dans un évidement intérieur de la culasse (2) tout en laissant subsister une fente (4) entre la culasse (2) et le rotor (3), et selon lequel on introduit dans la fente (4) un support d'instruments (1), qui porte des moyens (6,7,32) pour inspecter la machine, caractérisé par le fait que le support d'instruments (1) est repoussé contre la culasse (2) par au moins un aimant (11).

14. Procédé suivant la revendication 13, selon lequel le support d'instruments (1) roule sur la culasse (2) au moyen de premières roues (8).

15. Machine dynamoélectrique comportant un stator possédant une culasse ferromagnétique (2) et un rotor (3), qui est monté dans un évidement intérieur de la culasse (2) tout en laissant subsister une fente (4), et dans laquelle un support d'instruments (1) suivant l'une des revendications 1 à 12 est disposé dans la fente (4).
